# EUROPÄISCHE PATENTSCHRIFT

(11) **EP 0 448 828 B1**
(45) Veröffentlichungstag und Bekanntmachung des Hinweises auf die Patenterteilung: **22.11.1995**
(21) Anmeldenummer: 90125155.3
(22) Anmeldetag: 21.12.1990
(51) Int. Cl.: H03F 3/50, H03F 3/30

(54) **Emitterfolger-Schaltungsanordnung**
Emitter-follower circuit arrangement
Montage de circuit émetteur suiveur

(30) Priorität: 27.03.1990 DE 4009789
(43) Veröffentlichungstag der Anmeldung: 02.10.1991
(73) Patentinhaber: TEMIC TELEFUNKEN microelectronic GmbH, 74072 Heilbronn (DE)
(72) Erfinder: Tränkle, Günther, Dipl.-Phys., W-7910 Neu-Ulm 7 (DE)
(74) Vertreter: Maute, Hans-Jürgen, Dipl.-Ing.

(56) Entgegenhaltungen:
- DE-A- 4 003 462
- GB-A- 2 047 032
- US-A- 3 454 888
- US-A- 4 004 244
- US-A- 4 771 227
- ELEKTOR Bd. 2, Nr. 7-8, August1976, CANTERBURY,ENGLAND Seite 739;G.EBNER. 'Class A amplifier re-considered'

## Beschreibung

Die Erfindung betrifft eine Emitterfolger-Schaltungsanordnung nach dem Oberbegriff des Patentanspruchs 1.

Als Schaltungsanordnungen zur unsymmetrischen Speisung einer Last sind vor allem Gegentaktstufen in Niederfrequenzverstärkern für Audioanwendungen bekannt, siehe z.B. GB-A-2 047 032, US-A-3 454 888 und "Elektor", Bd.2, Nr. 7-8, Aug. 1976, Canterbury England, S. 739, G.Ebner: "Class A amplifier reconsidered". Diese Gegentaktstufen sind aber als Endstufen für Hochfrequenzanwendung im Regelfall nicht einsetzbar, weil die darin eingesetzten pnp-Transistoren zu niedrige Grenzfrequenzen aufweisen und weil diese Endstufen die bei hochfrequenter Signalübertragung häufig unerläßliche Impedanzanpassung nicht ermöglichen.

Zur unsymmetrischen Speisung einer Lastimpedanz mit einem hochfrequenten Wechselsignal kann eine Emitterfolger-Schaltungsanordnung eingesetzt werden, bei welcher zur Verringerung von Signalverzerrungen anstelle eines einfachen Emitterwiderstands eine Transistor-Stromquelle eingesetzt wird.

Der durch die Stromquelle eingestellte Ruhestrom, bei dem die maximale auftretende Aussteuerung der Emitterfolgerstufe durch ein Wechselspannungs-Nutzsignal bei Einhaltung ausreichender Ausgangsimpedanz berücksichtigt ist, verursacht aber relativ hohe Leistungsverluste, die insbesondere bei monolithischer Integration der Schaltungsanordnung problematisch sind. Für Großsignale an kleinen Lastimpedanzen ergeben sich bei herkömmlichen Emitterfolgern gleichfalls Impedanzanpassungsprobleme.

Aufgabe der vorliegenden Erfindung ist es daher, eine Emitterfolger-Schaltungsanordnung der im Oberbegriff des Patentanspruchs 1 genannten Art anzugeben, die geringere Verlustleistungswerte aufweist und bei guter Impedanzanpassung hohe Ausgangsleistungen ermöglicht.

Die erfindungsgemäße Lösung dieser Aufgabe ist durch die Merkmale des Patentanspruchs 1 gegeben. Die Unteransprüche enthalten vorteilhafte Ausgestaltungen und Weiterbildungen der Erfindung.

Die erfindungsgemäße Schaltungsanordnung ermöglicht durch Impedanzanpassung die Einhaltung eines vorgegebenen maximalen Stehwellenverhältnisses (oder minimaler Rückflußdämpfung). Die Ausgangsimpedanz der Schaltungsanordnung ist dabei im wesentlichen gegeben durch den als Emitterfolger geschalteten Transistor, dessen Eingangsbeschaltung und ggf. einen Serienwiderstand. Die vom Ausgang her gesehen parallel zu dem Emitterfolger-Transistor liegende Stromquelle ist vergleichsweise hochohmig und kann für die Impedanzanpassung vernachlässigt werden.

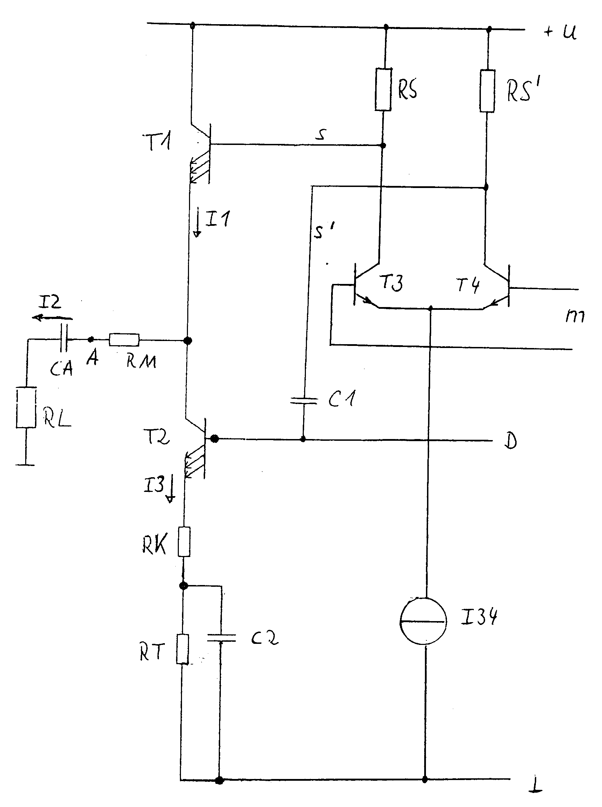

Die Erfindung ist nachfolgend anhand eines bevorzugten Ausführungsbeispiels unter Bezugnahme auf die Abbildung noch erläutert.

Die Schaltungsanordnung besteht in Analogie zu üblichen Emitterfolger-Schaltungen aus z. B. einem Multiemitter-Transistor T1, dessen Emitter zum einen mit der Last RL zum anderen mit einer Stromquelle, gebildet durch den weiteren Multiemitter-Transistor T2 mit Gegenkopplungselementen RK, RT und C2 verbunden ist. Der Kollektor von T1 ist mit dem Versorgungspotential +U verbunden und wird durch das Wechselspannungs-Steuersignal s ausgesteuert.

Wesentlich an der Erfindung ist, daß ein zu dem Steuersignal s komplementäres Signal s′ an die Basis des Transistors T2 angelegt ist und den Stromfluß durch die Stromquelle komplementär zur Aussteuerung des Transistors T1 moduliert. Das komplementäre Signal s′ ist über eine Kapazität C1 an die Basis der Transistor T2 angelegt, deren Gleichspannungspotential auf D eingestellt ist. Die Signale s, s′ sind mittels einer Differenzverstärkerstufe (Transistoren T3, T4 mit Lastwiderständen RS, RS′ und Stromquelle I34) aus einem symmetrischen Signal m abgeleitet. Die Signale s, s′ können durch unterschiedlich dimensionierte Lastwiderstände RS, RS′ verschiedene Amplituden aufweisen.

Als Stromgegenkopplung für das komplementäre Wechselspannungssignal in der Stromquelle wirkt nur der Widerstand RK, während der Widerstand RT als eine zusätzliche Gleichstromgegenkopplung zur Linearisierung und zur Stabilisierung des Temperaturverhaltens dient und für die Wechselstromanteile durch die Kapazität C2 überbrückt ist.

Der Widerstandswert von RK liegt vorteilhafterweise in der Größenordnung der Lastimpedanz RL und ist vorzugsweise gleich RL bzw. im skizzierten Beispiel gleich der Summe aus der Lastimpedanz RL und einem zur Impedanzanpassung in die Ausgangsleitung eingefügten Serienwiderstand RM.

Im Beispielsfall ist die Lastimpedanz über den Kondensator CA kapazitiv angekoppelt. Die Kapazitäten können, insbesondere für sehr hochfrequente Signale s, s′, als integrierte Kapazitäten realisiert sein.

Als Beispiel sei eine typische Lastimpedanz von RL = 50 Ohm angenommen, welche mit einem Stehwellenverhältnis von VSWR < 2 betrieben werden soll. Die Stromquelle mit T2 ist vom Ausgang gesehen hochohmig gegenüber der Lastimpedanz und bleibt im folgenden unberücksichtigt. Der durch RS gegebene Basisvorwiderstand von beispielsweise 500 Ohm wird um den Stromverstärkungsfaktor β, z. B. β = 50, des Transistors T1 reduziert mit 10 Ohm am Ausgang wirksam. Bei maximalem Strom I_{1 max} durch T1 entsprechend dem Scheitelwert von S wird der Beitrag des Transistors T1 zum Ausgangswiderstand als klein gegenüber RS/β angesehen.

Bahnwiderstände seien gleichfalls nicht mit berücksichtigt. Zum Erreichen des für VSWR < 2 minimalen Ausgangswiderstands von 25 Ohm am Ausgangsanschluß A ist daher ein Serienwiderstand RM > 15 Ohm einzufügen. Der Strom I3 durch den Stromquellentransistor T2 nimmt dabei einen Minimalwert an.

Für minimalen Strom I1 durch T1, d. h. s minimal und s′ maximal, soll wegen VSWR < 2 der Ausgangswiderstand der Schaltungsanordnung RAₘₐₓ < 100 Ohm sein. Der Beitrag des Transistors T1 ist durch die bekannte Beziehnung U_{T}/I₁ gegeben, woraus sich über
(U_{T}/I₁ + RS/β + RM) < RAₘₐₓ
U_{T}/I₁ < 75 Ohm
ein dynamischer Minimalwert für den Strom durch T1 mit I_{1 min} > 0,35 mA ergibt. Der Strom von der Last zum Schaltungsausgang A fließt durch die Stromquelle.

Im Kleinsignalbetrieb ergibt sich für optimale Anpassung R_{A soll} = 50 Ohm ein Ruhestrom durch T1 in der Größe von 1 mA. Die Dimensionierung der Stromquelle mit T2, RT, RK, C2 und D ergibt sich nach gebräuchlichen Prinzipien. Dabei ist vor allem zu beachten, daß der Minimalstrom I_{1 min} nicht unterschritten wird. Die Stromquelle kann auch durch mehrere parallelgeschaltete Teilquellen, z. B. eine für Gleichsignalanteil und I_{1 min}, eine für Wechselsignalanteil, o. ä. realisiert sein.

Wesentlich ist, daß die beschriebene Schaltungsanordnung mit den geringen Rest- bzw. Ruheströmen das vorgegebene VSWR < 2 auch für Ausgangsstromamplituden, die weit über dem Kleinsignalruhestrom liegen, gewährleistet.

Neben der anhand der Abbildung erläuterten unsymmetrischen Speisung einer Last kann die Schaltungsanordnung auch zur symmetrischen Speisung einer Last eingesetzt werden, indem zwei gleich aufgebaute Emitterfolger mit gesteuerter Stromquelle im Strompfad hintereinander angeordnet sind und die Last mit den beiden Emitterausgängen verbunden ist. Die Ansteuersignale s, s′ sind im zweiten Emitterfolger vertauscht an die Steueranschlüsse von Emitterfolger-Transistor und Stromquelle angelegt.

Die gesamte Schaltungsanordnung weist Transistoren nur des npn-Typs auf und ist damit auch für sehr hohe Frequenzen geeignet.

## Patentansprüche

1. Emitterfolger-Schaltungsanordnung, die zur unsymmetrischen Speisung einer Lastimpedanz (RL) mit einem Wechselsignal nach Maßgabe eines Steuersignals (s) im Emitterzweig eine Stromquelle aus einem Stromquellen-Transistor (T2) in Emitterschaltung, einem Emitterwiderstand (RK) und einen Steuereingang aufweist, an dem zur Steuerung ihres Stromes ein zum Steuersignal (s) komplementäres Signal (s′) angelegt ist, dadurch gekennzeichnet,
- daß die Ausgangsimpedanz der Schaltungsanordnung derart an die Lastimpedanz (RL) angepaßt ist, daß die Einhaltung eines vorgegebenen maximalen Stehwellenverhältnisses gewährleistet ist,
- und daß der Emitterwiderstand (RK) eine Stromgegenkopplung für das dem Stromquellen-Transistor (T2) zugeführte komplementäre Signal (s′) bildet.

2. Schaltungsanordnung nach Anspruch 1, dadurch gekennzeichnet, daß der Emitterwiderstand (RK) einen in der Größenordnung der Lastimpedanz (RL) liegenden Widerstandswert aufweist.

3. Schaltungsanordnung nach Anspruch 1 oder 2, dadurch gekennzeichnet, daß in die Ausgangsleitung ein Serienwiderstand (RM) zur Impedanzanpassung eingefügt ist.

4. Schaltungsanordnung nach einem der Ansprüche 1 bis 3, dadurch gekennzeichnet, daß die Lastimpedanz kapazitiv (CA) angekoppelt ist.

5. Schaltungsanordnung nach einem der Ansprüche 1 bis 4, dadurch gekennzeichnet, daß das Steuersignal (s) und das dazu komplementäre Signal (s′) aus einem symmetrischen Wechselsignal (m) abgeleitet sind.

6. Schaltungsanordnung nach einem der vorhergehenden Ansprüche, dadurch gekennzeichnet, daß die Stromquelle einen weiteren Gegenkopplungswiderstand (RT) enthält, der nur für Gleichstrom, nicht aber für das komplementäre Signal wirksam ist.

## Claims

1. An emitter follower circuit arrangement which for the asymmetrical supply of an alternating signal to a load impedance (RL) in accordance with a control signal (s) in the emitter branch comprises a current source composed of a current source transistor (T2) connected in a common emitter circuit, an emitter resistor (RK) and a control input to which a signal (s′) complementary to the control signal (s) is applied for the control of the current of said current source, characterised in that
- the output impedance of the circuit arrangement is adapted to the load impedance (RL) in such manner that adherence to a predetermined, maximum voltage standing wave ratio is ensured,
- and that the emitter resistor (RK) forms a negative current feedback for the complementary signal (s′) supplied to the current source transistor (T2).

2. A circuit arrangement as claimed in Claim 1, characterised in that the emitter resistor (RK) possesses a resistance value in the order of magnitude of the load impedance (RL).

3. A circuit arrangement as claimed in Claim 1 or 2, characterised in that a series resistor (RM) for the impedance matching is inserted into the output line.

4. A circuit arrangement as claimed in one of Claims 1 to 3, characterised in that the load impedance is capacitively (CA) coupled.

5. A circuit arrangement as claimed in one of Claims 1 to 4, characterised in that the control signal (s) and the signal (s′) complementary thereto are derived from a symmetrical alternating signal (m).

6. A circuit arrangement as claimed in one of the preceding claims, characterised in that the current source contains a further negative feedback resistor (RT) which is operative only for direct current (d.c.) but not for the complementary signal.

## Revendications

1. Circuit à charge d'émetteur, qui présente, en vue de l'alimentation asymétrique d'une impédance de charge (RL) avec un signal alternatif selon la grandeur d'un signal de commande (s), dans la branche d'émetteur, une source de courant se composant d'un transistor de source de courant (T2) dans le circuit d'émetteur, d'une résistance d'émetteur (RK) et d'une entrée de commande, à laquelle est appliqué en vue de la commande de son courant un signal (s′) complémentaire du signal de commande (s), caractérisé en ce que
- l'impédance de sortie du circuit est adaptée à l'impédance de charge (RL) de telle sorte que le maintien d'un taux d'ondes stationnaires maximal prescrit est garanti,
- et en ce que la résistance d'émetteur (RK) forme une contre-réaction de courant le signal complémentaire (s′) appliqué au transistor de source de courant (T2).

2. Circuit selon la revendication 1, caractérisé en ce que la résistance d'émetteur (RK) présente une valeur ohmique de l'ordre de grandeur de l'impédance de charge (RL).

3. Circuit selon la revendication 1 ou 2, caractérisé en ce que dans la ligne de sortie est insérée une résistance série (RM) en vue de l'adaptation d'impédance.

4. Circuit selon l'une des revendications 1 à 3, caractérisé en ce que l'impédance de charge est couplée capacitivement (CA).

5. Circuit selon l'une des revendications 1 à 4, caractérisé en ce que le signal de commande (s) et le signal (s′) complémentaire de celui-ci sont prélevés à partir d'un signal alternatif symétrique (m).

6. Circuit selon l'une des revendications précédentes, caractérisé en ce que la source de courant contient une autre résistance de contre-réaction (RT), qui agit uniquement pour le courant continu, mais pas pour le signal complémentaire.
